(19) Europäisches Patentamt / European Patent Office / Office européen des brevets

(11) **EP 4 682 551 A1**

(12)

# EUROPEAN PATENT APPLICATION
published in accordance with Art. 153(4) EPC

(43) Date of publication:
**21.01.2026 Bulletin 2026/04**

(21) Application number: **24770487.7**

(22) Date of filing: **26.02.2024**

(51) International Patent Classification (IPC):
**G01R 27/08** (2006.01)   **H05B 3/00** (2006.01)

(52) Cooperative Patent Classification (CPC):
**G01R 27/02; G01R 27/08; H05B 3/00**

(86) International application number:
**PCT/JP2024/006712**

(87) International publication number:
**WO 2024/190375 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.03.2023   JP 2023040061**

(71) Applicant: **OMRON Corporation
Kyoto 600-8530 (JP)**

(72) Inventors:
• **WAKABAYASHI, Takeshi
  Kyoto-shi, Kyoto 600-8530 (JP)**
• **YAMADA, Takaaki
  Kyoto-shi, Kyoto 600-8530 (JP)**
• **TSUBATA, Hajime
  Kyoto-shi, Kyoto 600-8530 (JP)**

(74) Representative: **HGF
HGF Limited
4th Floor, 1 City Square
Leeds LS1 2AL (GB)**

(54) **METHOD, PROGRAM, AND DEVICE**

(57) A method includes: acquiring at least two line voltage values among a line voltage value of a first electric wire and a second electric wire, a line voltage value of the second electric wire and a third electric wire, and a line voltage value of the third electric wire and the first electric wire, and at least two line current values among the first electric wire, the second electric wire, and the third electric wire; and calculating a resistance value of each phase of a three-phase heater based on the at least two line voltage values and the at least two line current values. The at least two line voltage values and line current values in each of a first state in which no current flows through only the first electric wire and in a second state in which no current flows through only the second electric wire are acquired.

Fig. 16

EP 4 682 551 A1

**Description**

TECHNICAL FIELD

The present disclosure relates to a method, a program, and a device configured to calculate a resistance value of each phase of a three-phase heater.

BACKGROUND ART

Patent Document 1 discloses a three-phase heater resistance value detection device that calculates each resistance value of three resistors based on power consumption consumed by a three-phase heater having three resistors and an effective value related to current or voltage applied to the three-phase heater.

PRIOR ART DOCUMENT

PATENT DOCUMENT

Patent Document 1: JP 2020-148697 A

SUMMARY OF THE INVENTION

PROBLEMS TO BE SOLVED BY THE INVENTION

The device of Patent Document 1 has room for improvement in terms of easily calculating a resistance value of each phase of the three-phase heater.
An object of the present disclosure is to provide a method, a program, and a device capable of easily calculating a resistance value of each phase of a three-phase heater.

SOLUTIONS TO THE PROBLEMS

A method according to an aspect of the present disclosure is a method including:

acquiring at least two line voltage values among a line voltage value of a first electric wire and a second electric wire, a line voltage value of the second electric wire and a third electric wire, and a line voltage value of the third electric wire and the first electric wire, and at least two line current values among a line current value of the first electric wire, a line current value of the second electric wire, and a line current value of the third electric wire, the first electric wire, the second electric wire, and the third electric wire respectively connecting a three-phase heater and a three-phase power supply, the three-phase heater including three resistors; and
calculating a resistance value of each phase of the three-phase heater based on the acquired at least two line voltage values and the acquired at least two line current values, wherein
the at least two line voltage values and the at least two line current values in each of a first state and a second state are acquired, the first state being a state in which no current flows through only the first electric wire, the second state being a state in which no current flows through only the second electric wire.

A program according to an aspect of the present disclosure is a program fo causing a computer to execute a method including:

acquiring at least two line voltage values among a line voltage value of a first electric wire and a second electric wire, a line voltage value of the second electric wire and a third electric wire, and a line voltage value of the third electric wire and the first electric wire, and at least two line current values among a line current value of the first electric wire, a line current value of the second electric wire, and a line current value of the third electric wire, the first electric wire, the second electric wire, and the third electric wire respectively connecting a three-phase heater and a three-phase power supply, the three-phase heater including three resistors; and
calculating a resistance value of each phase of the three-phase heater based on the acquired at least two line voltage values and the acquired at least two line current values, wherein
the at least two line voltage values and the at least two line current values in each of a first state and a second state are acquired, the first state being a state in which no current flows through only the first electric wire, the second state being a state in which no current flows through only the second electric wire.

A device according to an aspect of the present disclosure includes:

an acquisition unit configured to acquire at least two line voltage values among a line voltage value of a first electric wire and a second electric wire, a line voltage value of the second electric wire and a third electric wire, and a line voltage value of the third electric wire and the first electric wire, and at least two line current values among a line current value of the first electric wire, a line current value of the second electric wire, and a line current value of the third electric wire, the first electric wire, the second electric wire, and the third electric wire respectively connecting a three-phase heater and a three-phase power supply, the three-phase heater including three resistors; and
a calculation unit configured to calculate a resistance value of each phase of the three-phase heater based on the acquired at least two line voltage values and the acquired at least two line current values, wherein
the acquisition unit is configured to acquire the at least two line voltage values and the at least two line current values in each of a first state and a second state, the first state being a state in which no current flows through only the first electric wire, the second state being a state in which no current flows through only the second electric wire.

EFFECTS OF THE INVENTION

According to the present disclosure, it is possible to realize a method, a program, and a device capable of easily calculating a resistance value of each phase of a three-phase heater.

BRIEF DESCRIPTION OF THE DRAWINGS

[Fig. 1] Fig. 1 is a block diagram showing a device according to an embodiment of the present disclosure.

[Fig. 2] Fig. 2 is a block diagram showing a three-phase heater in which three resistors are delta-connected.

[Fig. 3] Fig. 3 is a graph showing an example of a current waveform of each electric wire when current supplied to a three-phase heater is adjusted by an adjustment unit including three SSRs.

[Fig. 4] Fig. 4 is a graph for explaining a characteristic of triac SSR.

[Fig. 5] Fig. 5 is a graph showing an example of a current waveform of each electric wire when current supplied to a three-phase heater is adjusted by an adjustment unit including a power regulator.

[Fig. 6] Fig. 6 is a first block diagram showing a first state of the three-phase heater of Fig. 2.

[Fig. 7] Fig. 7 is a first block diagram showing a second state of the three-phase heater of Fig. 2.

[Fig. 8] Fig. 8 is a first block diagram showing a third state of the three-phase heater of Fig. 2.

[Fig. 9] Fig. 9 is a second block diagram showing a first state of the three-phase heater of Fig. 2.

[Fig. 10] Fig. 10 is a second block diagram showing a second state of the three-phase heater of Fig. 2.

[Fig. 11] Fig. 11 is a second block diagram showing a third state of the three-phase heater of Fig. 2.

[Fig. 12] Fig. 12 is a block diagram showing a three-phase heater in which three resistors are star-connected.

[Fig. 13] Fig. 13 is a block diagram showing a first state of the three-phase heater of Fig. 12.

[Fig. 14] Fig. 14 is a block diagram showing a second state of the three-phase heater of Fig. 12.

[Fig. 15] Fig. 15 is a block diagram showing a third state of the three-phase heater of Fig. 12.

[Fig. 16] Fig. 16 is a flowchart showing an example of a method according to the present disclosure.

DETAILED DESCRIPTION

Hereinafter, an example of the present disclosure will be described with reference to the accompanying drawings. The following description is merely exemplary in nature and is not intended to limit the present disclosure, application of the present disclosure, or use of the present disclosure. The drawings are schematic, and ratios of dimensions and the like do not necessarily match actual ones.

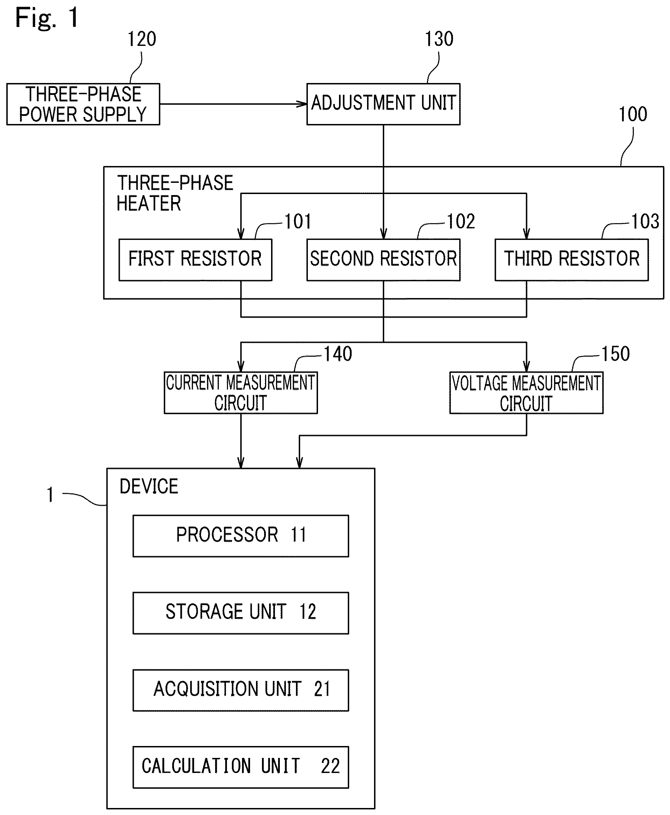

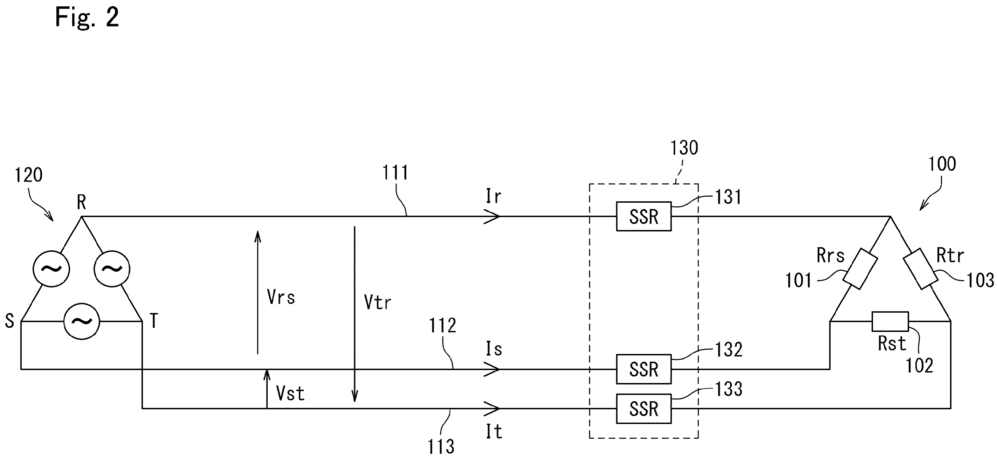

A device 1 according to an embodiment of the present disclosure is configured to calculate a resistance value of each phase of a three-phase heater 100. As illustrated in Fig. 1, the three-phase heater 100 includes three resistors (hereinafter referred to as a first resistor 101, a second resistor 102, and a third resistor 103). As illustrated in Fig. 2, the three-phase heater 100 is connected to a three-phase power supply 120 via three electric wires (hereinafter referred to as a first electric wire 111, a second electric wire 112, and a third electric wire 113). An adjustment unit 130 is positioned between the three-phase heater 100 and the three-phase power supply 120. The adjustment unit 130 is configured to be controlled on and off, and configured such that current is supplied from the three-phase power supply 120 to the three-phase heater 100 when turning on.

In the present embodiment, as an example, the first resistor 101, the second resistor 102, and the third resistor 103 of the three-phase heater 100 are delta-connected, and the adjustment unit 130 includes three SSRs 131, 132, and 133. The second electric wire 112 and a second end of the second resistor 102 are electrically connected to a first end of the first resistor 101. The third electric wire 113 and a second end of the third resistor 103 are electrically connected to a first end of the second resistor 102. The first electric wire 111 and a second end of the first resistor 101 are electrically connected to a first end of the third resistor 103. The SSR 131 is configured to adjust current supplied to the three-phase heater 100 via the first electric wire 111. The SSR 132 is configured to adjust current supplied to the three-phase heater 100 via the second electric wire 112. The SSR 133 is configured to adjust current supplied to the three-phase heater 100 via the third electric wire 113. The SSRs 131, 132, and 133 are controlled by, for example, a common input signal.

A line current value Ir, Is, and It of each electric wire is detected by a current measurement circuit 140, and is transmitted to the device 1 as, for example, an analog signal. The current measurement circuit 140 is configured to detect at least two line currents. A line voltage value Vrs of the first electric wire 111 and the second electric wire 112, a line voltage value Vst of the second electric wire 112 and the third electric wire 113, and a line voltage value Vtr of the third electric wire 113 and the first electric wire 111 are detected by a voltage measurement circuit 150, and are transmitted to the device 1 as, for example, an analog signal. The voltage measurement circuit 150 is configured to detect at least two line voltage values.

As illustrated in Fig. 1, the device 1 includes an acquisition unit 21 and a calculation unit 22. In the present embodiment, the device 1 includes a processor 11 and a storage unit 12. The acquisition unit 21 and the calculation unit 22 are implemented, for example, by the processor 11 executing a predetermined program stored in the storage unit 12.

The processor 11 includes, for example, a CPU, an MPU, a GPU, a DSP, an FPGA, or an ASIC. The storage unit 12 includes, for example, an internal recording medium or an external recording medium. The internal recording medium includes a nonvolatile memory or the like. The external recording medium includes a hard disk (HDD), a solid state drive (SSD), an optical disk device, or the like.

The acquisition unit 21 is configured to acquire at least two line voltage values among the line voltage value Vrs of the first electric wire 111 and the second electric wire 112, the line voltage value Vst of the second electric wire 112 and the third electric wire 113, and the line voltage value Vtr of the third electric wire 113 and the first electric wire 111, and at least two line current values among the line current value of the first electric wire 111, the line current value of the second electric wire 112, and the line current value of the third electric wire 113. In the present embodiment, the acquisition unit 21 is configured to acquire the line voltage values Vrs, Vst, and Vtr and the line current values Ir, Is, and It at the same timing. The "same timing" is not limited to the completely same timing, and includes, for example, a timing within a range that can be regarded as the same in terms of performance of the current measurement circuit 140 and the voltage measurement circuit 150.

Specifically, the acquisition unit 21 is configured to acquire the line voltage values and the line current values in at least two of the following three states. The line voltage values Vrs, Vst, and Vtr and the line current values Ir, Is, and It are instantaneous values, and are acquired, for example, every constant sampling period. The acquired line voltage values Vrs, Vst, and Vtr and line current values Ir, Is, and It at sampling points are classified into any one of a first state, a second state, a third state, and other state. The other state is a state in which all three line current values Ir, Is, and It are zero, or a state in which none of the three line current values Ir, Is, and It are zero. Due to nature of the three-phase heater 100, a sum of the three line current values Ir, Is, and It and a sum of the three line voltage values Vrs, Vst, and Vtr are zero. If at least two line voltage values and at least two line current values can be acquired, the remaining one line voltage value and the remaining one line current value can be calculated from the acquired line voltage values and line current values. The remaining one line voltage value and the remaining one line current value may be calculated by an external device such as a server, or may be calculated by the device 1.

· (First State) A state in which no current is flowing through only one of the first electric wire 111, the second electric wire 112, and the third electric wire 113.

· (Second State) A state in which no current flows through only one of two electric wires excluding an electric wire through which no current flows in the first state among the first electric wire 111, the second electric wire 112, and the third electric wire 113. For example, when no current flows through the first electric wire 111 in the first state, no current flows through the second electric wire 112 or the third electric wire 113 in the second state.

· (Third State) A state in which no current flows through only one of the first electric wire 111, the second electric wire 112, and the third electric wire 113 excluding electric wires through which no current flows in the first state and the second state. For example, when no current flows through only the first electric wire 111 in the first state and no current flows through only the second electric wire 112 in the second state, no current flows through only the third electric wire in the third state.

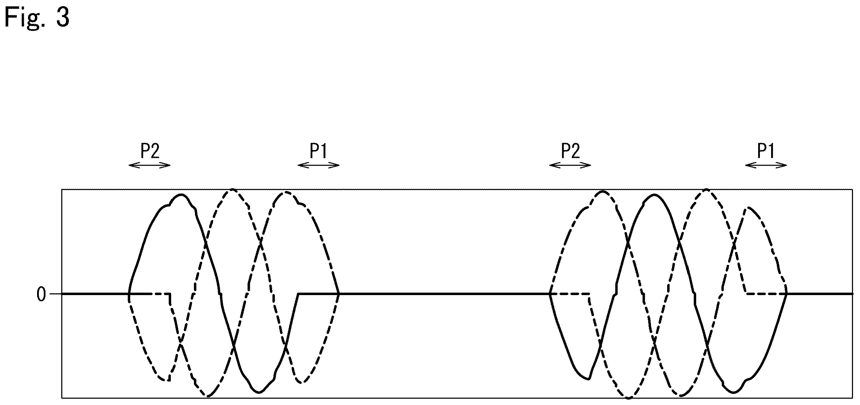

Fig. 3 shows an example of a current waveform of each electric wire when current supplied to the three-phase heater 100 is adjusted by the adjustment unit 130 including three solid state relays (SSR). In Fig. 3, the line current value Ir of the first electric wire 111 is indicated by a solid line, the line current value Is of the second electric wire 112 is indicated by a broken line, and the line current value It of the third electric wire 113 is indicated by a one-dot chain line. The adjustment unit 130 is not limited to a case of including the three SSRs, but only may include at least two SSRs.

In a normal AC waveform, a timing at which a current value is zero is a zero cross point of a current waveform, and it is considered that a sampling point does not coincide with the zero cross point. As illustrated in Fig. 3, in a triac SSR, an end of conduction (when turning on) is always the zero cross point of the line current value, and in a predetermined period P1 immediately before the SSR is switched from on to off, only one line current value of the three electric wires is always zero. Since the predetermined period P1 is a period having a width, there are many sampling points at which the line current value is zero if the sampling period is sufficiently smaller than a power supply period even if the sampling period is constant. That is, when the adjustment unit 130 is configured by the triac SSR, the line voltage values Vrs, Vst, and Vtr and the line current values Ir, Is, and It in the first state to the third state can be easily acquired.

In a SSR having a zero cross function among the triac SSRs, as illustrated in Fig. 3, a start of conduction is always the zero cross point of the line current value in addition to the end of conduction, and one line current value of the three electric wires is always zero in a predetermined period P2 immediately after the SSR is switched from off to on. That is, when the adjustment unit 130 includes the triac SSR having the zero cross function, the line voltage values Vrs, Vst, and Vtr and the line current values Ir, Is, and It in the first state to the third state can be easily acquired.

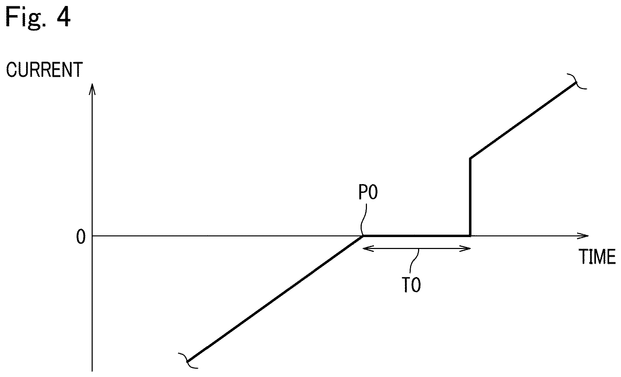

The triac SSR has a characteristic that a line current value is not a clean sine wave even when an output amount thereof is 100%, and as shown in Fig. 4, it once becomes non-conductive at a zero cross point P0 and then becomes conductive after a while (period T0 in which a current value is zero). That is, when the adjustment unit 130 includes the triac SSR, since there is a period having a width in which a line current value is zero for each zero cross point, for example, even when control of the output amount of 100% is continued and there are no start and end of conduction, the line voltage values Vrs, Vst, and Vtr and the line current values Ir, Is, and It in the first state to the third state can be easily acquired.

In the present specification, a SSR using a triac or a thyristor as a switch element is referred to as the "triac SSR".

The adjustment unit 130 is not limited to a case of including at least two SSRs, but may be configured by a power regulator configured to control a phase of current supplied from the three-phase power supply 120.

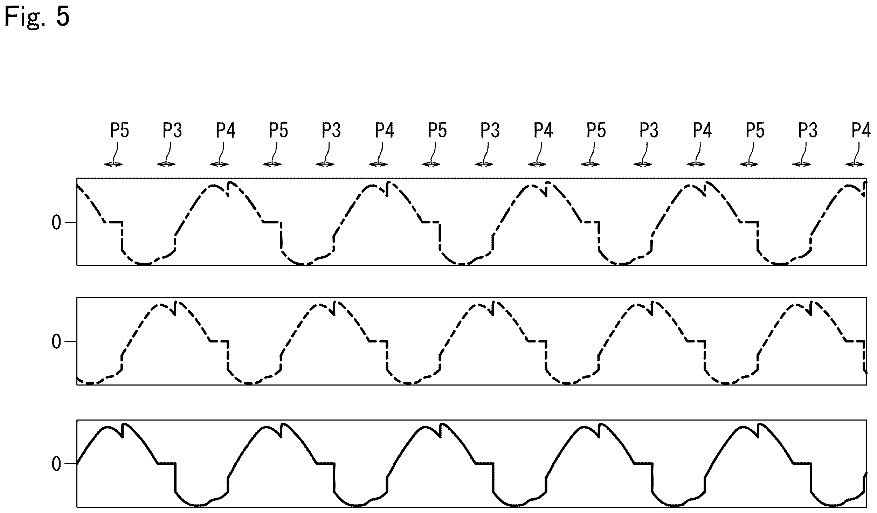

Fig. 5 shows an example of a current waveform of each electric wire when current supplied to the three-phase heater 100 is adjusted by the adjustment unit 130 including the power regulator. In Fig. 5, the line current value Ir of the first electric wire 111 is indicated by a solid line, the line current value Is of the second electric wire 112 is indicated by a broken line, and the line current value It of the third electric wire 113 is indicated by a one-dot chain line.

As shown in Fig. 5, in phase control by the power regulator, a period P3 in which only the line current value of the first electric wire 111 is zero, a period P4 in which only the line current value of the second electric wire 112 is zero, and a period P5 in which only the line current value of the third electric wire 113 is zero exist at least once in the power supply period. Since the predetermined periods P3 to P5 are periods having a width, there are many sampling points at which a line current value is zero if the sampling period is sufficiently smaller than the power supply period even if the sampling period is constant. That is, when the adjustment unit 130 includes the power regulator, the line voltage values Vrs, Vst, and Vtr and the line current values Ir, Is, and It in the first state to the third state can be easily acquired. When an output amount of the power regulator is 100%, a line current value of each electric wire has the same waveform as when the adjustment unit 130 includes the three SSRs and the output amount of each SSR is 100%.

When the adjustment unit 130 adjusts current supplied to the three-phase heater, a detected line current value may not be completely zero for the following two reasons.

· Since the SSR and the power regulator have a snubber circuit for noise countermeasures, a leakage current of about 10 to 20 mA is generated when the SSR and the power regulator are off (non-conductive).

· Due to a problem of measurement accuracy, a detected line current value may not be zero when the current is zero.

In the present embodiment, when one line current value of the acquired three line current values Ir, Is, and It is less than a first threshold (for example, 10 mA) and the remaining two line current values of the acquired three line current values Ir, Is, and It are greater than a second threshold (for example, 20 mA), the acquisition unit 21 determines that no current flows through only an electric wire corresponding to the line current value less than the first threshold. For example, it is assumed that the acquired line current value Ir of the first electric wire 111 is less than the first threshold, and the acquired line current values Is and It of the second electric wire 112 and the third electric wire 113 are greater than the second threshold. In this case, the acquisition unit 21 determines that no current flows through only the first electric wire 111.

Appropriate values of the first threshold and the second threshold are different depending on a current measurement range or the like. The first threshold is set, for example, within a range that allows determination of when the adjustment unit 130 is off and does not significantly affect measurement accuracy of the resistance value. The second threshold is set within a range that allows exclusion of a case where all of the acquired three line current values Ir, Is, and It are zero. The first threshold and the second threshold may be set in advance or may be settable by a user. For example, the second threshold is set to the same value as the first threshold or a value slightly greater than the first threshold (for example, about 10 mA).

The calculation unit 22 is configured to calculate the resistance value of each phase of the three-phase heater 100 based on the acquired line voltage values Vrs, Vst, and Vtr and the acquired line current values Ir, Is, and It.

For example, a state in which no current flows through only the first electric wire 111 is referred to as the first state, a state in which no current flows through only the second electric wire 112 is referred to as the second state, and a state in which no current flows through only the third electric wire 113 is referred to as the third state. In this case, the calculation unit 22 calculates at least a first combined resistance value R1 and a second combined resistance value R2 among the first combined resistance value R1, the second combined resistance value R2, and a third combined resistance value R3 of the three-phase heater 100 from the line voltage values Vrs, Vst, and Vtr and the line current values Ir, Is, and It in the first state, the second state, and the third state. When the first combined resistance value R1, the second combined resistance value R2, and the third combined resistance value R3 are calculated, the resistance value Rrs, Rst, and Rtr of each phase of the three-phase heater 100 is calculated from the calculated first combined resistance value R1, second combined resistance value R2, and third combined resistance value R3. When the first combined resistance value R1 and the second combined resistance value R2 are calculated, the resistance value of each phase of the three-phase heater 100 is calculated from the first combined resistance value R1 and the second combined resistance value R2, and ratios K and P of the resistance value of each phase of the three-phase heater 100.

The first combined resistance value R1, the second combined resistance value R2, and the third combined resistance value R3 are calculated, for example, as follows.

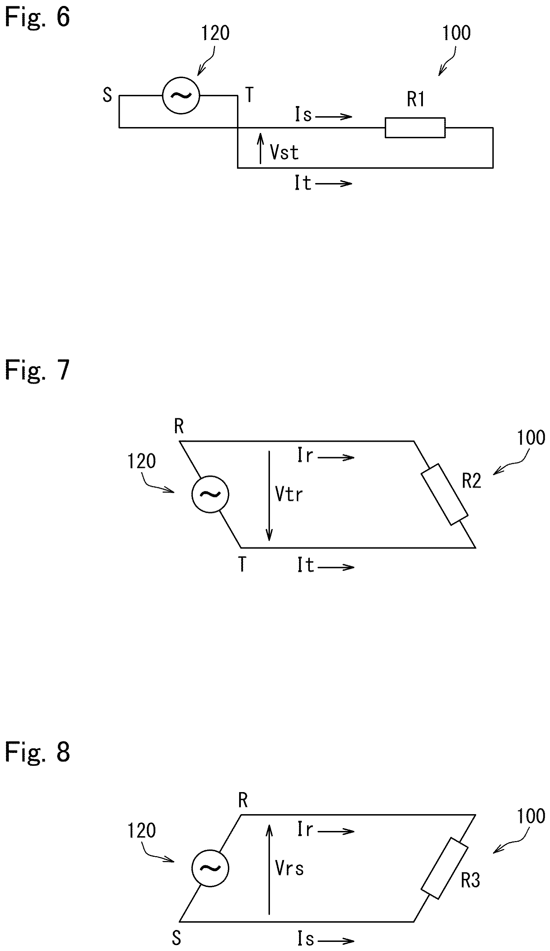

· The first combined resistance value R1 is calculated from an absolute value of the line current value Is of the second electric wire 112 or an absolute value of the line current value It of the third electric wire 113 in the first state, and an absolute value of the line voltage value Vst of the second electric wire 112 and the third electric wire 113 (see Fig. 6).
· The second combined resistance value R2 is calculated from an absolute value of the line current value Ir of the first electric wire 111 or an absolute value of the line current value It of the third electric wire 113 in the second state, and an absolute value of the line voltage value Vtr of the first electric wire 111 and the third electric wire 113 (see Fig. 7).
· The third combined resistance value R3 is calculated from an absolute value of the line current value Ir of the first electric wire 111 or an absolute value of the line current value Is of the second electric wire 112 in the third state, and an absolute value of the line voltage value Vrs of the first electric wire 111 and the second electric wire 112 (see Fig. 8).

The resistance value of each phase of the three-phase heater 100 is calculated, for example, from solutions of the following simultaneous equations. In the following simultaneous equations, f1, f2, and f3 are different functions depending on a wire connection method (for example, delta connection and star connection) of the three-phase heater 100.

<Delta Connection>

$$R1 = f1\ (Rrs,\ Rst,\ Rtr)$$

·

$$R2 = f2\ (Rrs,\ Rst,\ Rtr)$$

•

$$R3 = f3\ (Rrs, Rst, Rtr)$$

<Star Connection>

•

$$R1 = f1\ (Rs, Rt)$$

.

$$R2 = f2\ (Rt, Rr)$$

$$R3 = f3\ (Rr, Rs)$$

When the first combined resistance value R1, the second combined resistance value R2, and the third combined resistance value R3 are calculated using the acquired instantaneous values of the line voltage values Vrs, Vst, and Vtr and the line current values Ir, Is, and It in the first state to the third state, it is considered, for example, that calculation accuracy is reduced due to an input error of the instantaneous values. In the present embodiment, the calculation unit 22 calculates the first combined resistance value R1, the second combined resistance value R2, and the third combined resistance value R3 after smoothing the acquired instantaneous values of the line voltage values Vrs, Vst, and Vtr and the line current values Ir, Is, and It in the first state to the third state. Smoothing processing includes, for example, root mean square (RMS) processing, moving average processing, and first-order lag processing.

An example of a case where the first combined resistance value R1 is calculated by the RMS processing will be described below. For example, it is assumed that a calculation cycle of the first combined resistance value R1 is one second, and there is/are n sampling point(s) determined as "Ir = 0" in one second. Assuming that the instantaneous values of Is and Vst at the n-th sampling time are respectively "Is = Isn, Vst = Vstn", the RMS value of Is and the RMS value of Vst at the first to n-th time are calculated by the following formulas 1 and 2. When the first combined resistance value R1 is calculated by "R1 = Vst(rms)/Is(rms)", calculation accuracy of the first combined resistance value R1 can be improved.

[Formula 1]

$$Is(rms) = \sqrt{\frac{Is_1^2 + Is_2^2 + \cdots + Is_n^2}{n}}$$

[Formula 2]

$$Vst(rms) = \sqrt{\frac{Vst_1^2 + Vst_2^2 + \cdots + Vst_n^2}{n}}$$

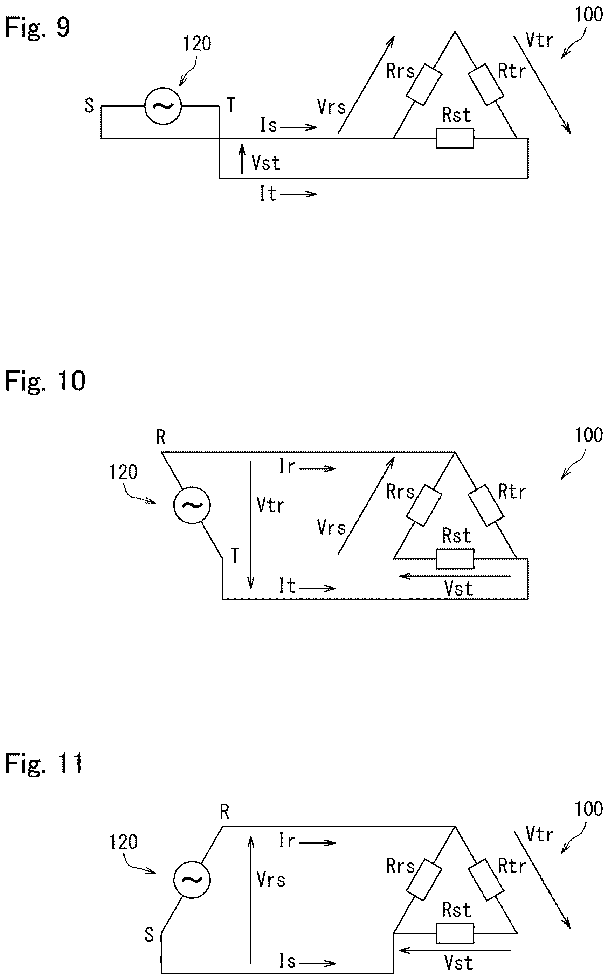

For example, in the three-phase heater 100 in which the three resistors shown in Fig. 2 are delta-connected, the resistance value Rrs, Rst, and Rtr of each phase of the three-phase heater 100 is calculated by the following formulas 6 to 8, which are obtained by the following formulas 3 to 5. That is, when the three resistors are delta-connected, the calculation unit 22 calculates the resistance value Rrs, Rst, and Rtr of each phase of the three-phase heater 100 without using a current value of each phase. In this case, for example, the acquisition unit 21 is configured not to acquire a current value of each phase of the three-phase heater 100. Fig. 9 shows the first state of the delta-connected three-phase heater 100, Fig. 10 shows the second state of the delta-connected three-phase heater 100, and Fig. 11 shows the third state of the delta-connected three-phase heater 100.

[Formula 3]

$$\frac{1}{R1} = \frac{1}{Rst} + \frac{1}{Rrs+Rtr}$$

[Formula 4]

$$\frac{1}{R2} = \frac{1}{Rtr} + \frac{1}{Rst+Rrs}$$

[Formula 5]

$$\frac{1}{R3} = \frac{1}{Rrs} + \frac{1}{Rtr+Rst}$$

[Formula 6]

$$Rrs = \frac{R1^2+R2^2+R3^2-2R1R2-2R2R3-2R3R1}{2(R3-R1-R2)}$$

[Formula 7]

$$Rst = \frac{R1^2+R2^2+R3^2-2R1R2-2R2R3-2R3R1}{2(R1-R2-R3)}$$

[Formula 8]

$$Rtr = \frac{R1^2+R2^2+R3^2-2R1R2-2R2R3-2R3R1}{2(R2-R3-R1)}$$

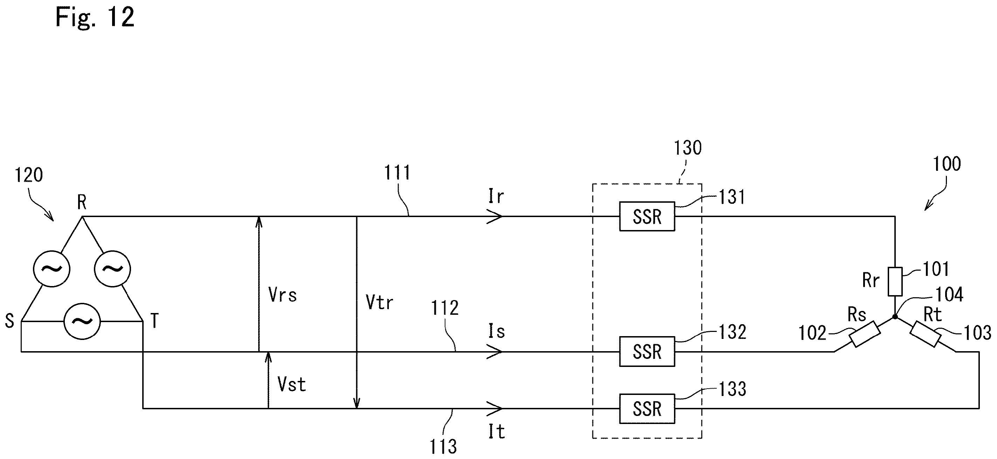

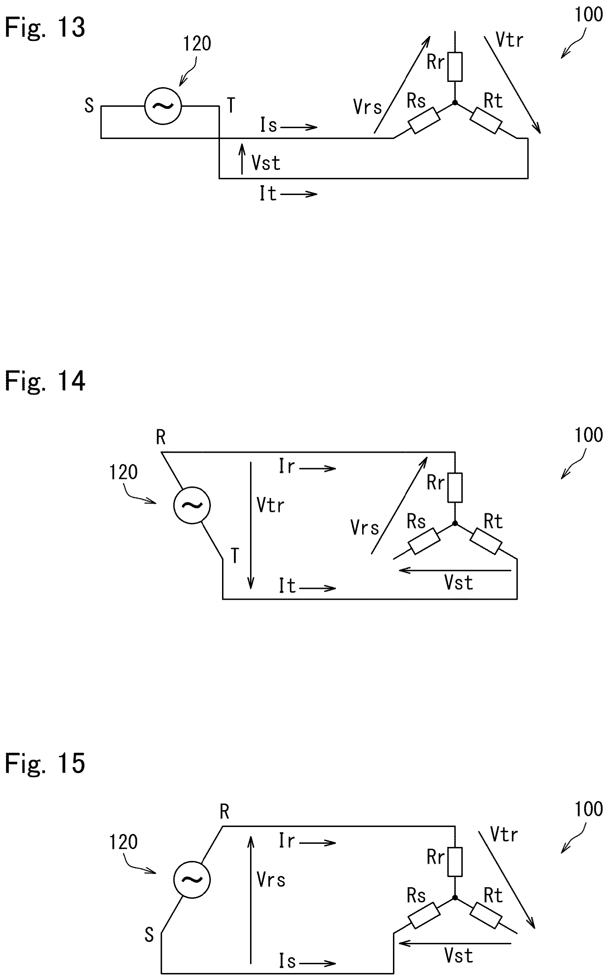

For example, in the three-phase heater 100 in which the three resistors 101, 102, and 103 shown in Fig. 12 are star-connected, the resistance value Rr, Rs, and Rt of each phase of the three-phase heater 100 is calculated by the following formula 12 to 14, which are obtained by the following formula 9 to 11. That is, when the three resistors 101, 102, and 103 are star connected, the calculation unit 22 calculates the resistance value Rr, Rs, and Rt of each phase of the three-phase heater 100 without using a voltage value of each phase. In this case, the acquisition unit 21 is configured not to acquire a voltage value of a neutral point 104 of the three-phase heater 100. Fig. 13 shows the first state of the star-connected three-phase heater 100, Fig. 14 shows the second state of the star-connected three-phase heater 100, and Fig. 15 shows the third state of the star-connected three-phase heater 100.

[Formula 9]

$$R1 = Rs + Rt$$

[Formula 10]

$$R2 = Rt + Rr$$

[Formula 11]

$$R3 = Rr + Rs$$

[Formula 12]

$$Rs = \frac{1}{2}(R1 + R3 - R2)$$

[Formula 13]

$$Rt = \frac{1}{2}(R2 + R1 - R3)$$

[Formula 14]

$$Rr = \frac{1}{2}(R3 + R2 - R1)$$

For example, in Fig. 2, when the SSR 133 is not provided (that is, when the adjustment unit 130 includes two SSRs 131 and 132), the resistance value Rrs, Rst, and Rtr of each phase of the three-phase heater 100 is calculated by Formula 17 to 19, which are obtained by Formula 3, Formula 4, and Formula 15, or by Formula 20 to 22, which are obtained by Formula 3, Formula 4, and Formula 16. K is a ratio calculated by Vtr/Vrs, and P is a ratio calculated by Vrs/Vst. In this case, for example, the acquisition unit 21 is configured not to acquire a current value of each phase of the three-phase heater 100.

[Formula 15]

$$K = \frac{Rtr}{Rrs}$$

[Formula 16]

$$P = \frac{Rrs}{Rst}$$

[Formula 17]

$$Rst = \frac{R1\{K^2(R1-R2)-2KR2-R2\}}{(K+1)\{K(R1-R2)-R2\}}$$

[Formula 18]

$$Rtr = \frac{-\{K^2(R1-R2)-2KR2-R2\}}{K+1}$$

[Formula 19]

$$Rrs = \frac{K^2(R1-R2)-2KR2-R2}{K(K+1)}$$

[Formula 20]

$$Rst = \frac{R1(P+1)^2-R2}{P(P+1)}$$

[Formula 21]

$$Rtr = \frac{R2\{R1(P+1)^2-R2\}}{(P+1)\{R1(P+1)-R2]}$$

[Formula 22]

$$Rrs = \frac{R1(P+1)^2-R2}{P+1}$$

For example, in Fig. 12, when the SSR 133 is not provided (that is, when the adjustment unit 130 includes two SSRs 131 and 132), the resistance value Rr, Rs, and Rt of each phase of the three-phase heater 100 is calculated by Formula 25 to 27, which are obtained by Formula 9, Formula 10, and Formula 23, or by Formula 28 to 30, which are obtained by Formula 9, Formula 10, and Formula 24. K is a ratio calculated by Vtr/Vrs, and P is a ratio calculated by Vrs/Vst. In this case, the acquisition unit 21 is configured not to acquire a voltage value based on the neutral point 104 of the three-phase heater 100.

[Formula 23]

$$K = \frac{Rt}{Rs}$$

[Formula 24]

$$P = \frac{Rr}{Rt}$$

[Formula 25]

$$Rr = R2 - \frac{KR1}{K+1}$$

[Formula 26]

$$Rs = \frac{R1}{K+1}$$

[Formula 27]

$$Rt = \frac{KR1}{K+1}$$

[Formula 28]

$$Rr = \frac{PR2}{P+1}$$

[Formula 29]

$$Rs = R1 - \frac{R2}{P+1}$$

[Formula 30]

$$Rt = \frac{R2}{P+1}$$

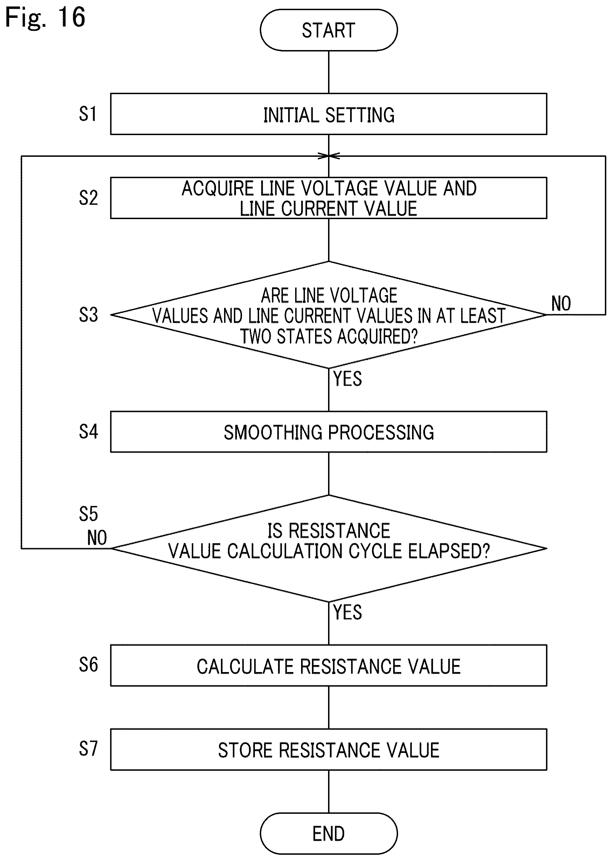

With reference to Fig. 16, processing of calculating the resistance value of each phase of the three-phase heater 100 of Fig. 2 or 12 (an example of a method according to the present disclosure) will be described. As an example, processing shown in Fig. 6 is performed by the processor 11 executing a predetermined program stored in the storage unit 12.

As illustrated in Fig. 16, when the processing of calculating the resistance value of each phase of the three-phase heater 100 is started, an initial setting is performed (step S1). The initial setting includes, for example, the following settings.

· Wire connection method of three-phase heater 100 (for example, delta connection or star connection)

· The number of SSRs or power regulators constituting the adjustment unit 130 (for example, zero, two, or three)
· Resistance value calculation cycle (for example, 1 second)

When the initial setting is performed, the acquisition unit 21 acquires (for example, simultaneously) the line voltage values Vrs, Vst, and Vtr and the line current values Ir, Is, and It (step S2). A cycle of acquiring the line voltage values Vrs, Vst, and Vtr and the line current values Ir, Is, and It may be a constant cycle using a timer interruption or the like, and is preferably sufficiently smaller than the power supply period. In this case, steps S2 to S5 to be described later are performed once in an acquisition cycle, and steps S6 and S7 are performed once in a resistance value calculation cycle.

When the line voltage values Vrs, Vst, and Vtr and the line current values Ir, Is, and It are acquired, the calculation unit 22 determines whether the line voltage values Vrs, Vst, and Vtr and the line current values Ir, Is, and It in at least two states among the first state to the third state are acquired (step S3). For example, the calculation unit 22 classifies the acquired line current values Ir, Is, and It into the first state to the third state every time the line voltage values Vrs, Vst, and Vtr and the line current values Ir, Is, and It are acquired in the acquisition cycle. From a classified result, it is determined whether the line voltage values Vrs, Vst, and Vtr and the line current values Ir, Is, and It in at least two states are acquired. When it is not determined that the line voltage values Vrs, Vst, and Vtr and the line current values Ir, Is, and It in at least two states are acquired, the process returns to step S2, and the line voltage values Vrs, Vst, and Vtr and the line current values Ir, Is, and It are acquired at a next acquisition timing.

When it is determined that the line voltage values Vrs, Vst, and Vtr and the line current values Ir, Is, and It in at least two states are acquired, the calculation unit 22 performs the smoothing processing on the acquired line voltage values Vrs, Vst, and Vtr and line current values Ir, Is, and It (step S4). For example, the smoothing processing targets data of the line voltage values and the line current values in at least two states. The smoothing processing includes newly sampling, adding a sampling value matching any one of the first state to the third state to a smoothed value of a previous first state to third state, and re-smoothing it.

When the smoothing processing is performed on the acquired line voltage values Vrs, Vst, and Vtr and line current values Ir, Is, and It, the calculation unit 22 determines whether a set resistance value calculation cycle is elapsed (step S5). When it is determined that the set resistance value calculation cycle is elapsed, the calculation unit 22 calculates the resistance value of each phase of the three-phase heater 100 based on the smoothed line voltage values Vrs, Vst, and Vtr and the smoothed line current values Ir, Is, and It (step S6).

When the resistance value of each phase of the three-phase heater 100 is calculated, the calculated resistance value is stored in the storage unit 12 (step S7), and the processing of calculating the resistance value is terminated. When it is not determined that the set resistance value calculation cycle is elapsed, the process returns to step S2, and the line voltage values Vrs, Vst, and Vtr and the line current values Ir, Is, and It are acquired at the next acquisition timing.

According to the method of the present disclosure, the following effects can be exhibited.

In general, in a three-phase heater having three resistors, it may be structurally difficult to measure a phase voltage value or a phase current value of each phase. For example, it may be difficult to measure a phase current value in a three-phase heater in which three resistors are delta-connected, and it may be difficult to measure a phase voltage value in a three-phase heater in which three resistors are star-connected. Line current values and line voltage values of three wires connecting a three-phase heater and a three-phase power supply can be relatively easily measured. Therefore, when calculating a resistance value of each phase of a three-phase heater, it is considered to use line voltage values and line current values.

In the invention of Patent Document 1, in order to calculate a resistance value of each phase of a three-phase heater, a line voltage value, a line current value, and power consumption calculated from a line voltage value and a line current value are used. Therefore, calculation for calculating a resistance value of each phase of a three-phase heater is complicated, and a resistance value of each phase of a three-phase heater may not be easily calculated.

The method of the present disclosure includes the following configuration. With such a configuration, the resistance value of each phase of the three-phase heater 100 can be calculated from the line voltage values Vrs, Vst, and Vtr and the line current values Ir, Is, and It, so that the resistance value of each phase of the three-phase heater 100 can be easily calculated. In addition, in the method of the present disclosure, the resistance value of each phase of the three-phase heater 100 can be calculated using only the instantaneous values of the line voltage values Vrs, Vst, and Vtr and the line current values Ir, Is, and It or only values that the instantaneous values are smoothed.

· Acquiring at least two line voltage values among the line voltage value Vrs of the first electric wire 111 and the second electric wire 112, the line voltage value Vst of the second electric wire 112 and the third electric wire 113, and the line voltage value Vtr of the third electric wire 113 and the first electric wire 111, and at least two line current values among the line current value of the first electric wire 111, the line current value of the second electric wire 112, and the line current value of the third electric wire 113. The first electric wire 111, the second electric wire 112, and the third electric wire 113 respectively connect the three-phase heater 100 and the three-phase power supply 120, the three-phase heater 100 including three resistors.

· Calculating the resistance value of each phase of the three-phase heater 100 based on the acquired at least two line voltage values Vrs, Vst, and Vtr and the acquired at least two line current values Ir, Is, and It.

· The at least two line voltage values Vrs, Vst, and Vtr and the at least two line current values Ir, Is, and It in each of the first and second states are acquired. In the first state, no current flows through only one of the first electric wire 111, the second electric wire 112, and the third electric wire 113. In the second state, no current flows through only one of the two electric wires excluding the electric wire through which no current flows in the first state among the first electric wire 111, the second electric wire 112, and the third electric wire 113.

The method of the present disclosure may arbitrarily employ any one or more of the following configurations. That is, any one or more of the following configurations may be arbitrarily deleted when included in the embodiment, and may be arbitrarily added when not included in the embodiment. By employing such a configuration, the resistance value of each phase of the three-phase heater can be calculated more easily.

When the acquired at least two line current values include three acquired line current values,, one line current value of the acquired three line current values Ir, Is, and It is less than the first threshold and the remaining two line current values of the acquired three line current values Ir, Is, and It are greater than the second threshold, it is determined that no current is flowing through an electric wire corresponding to the one line current value less than the first threshold. With such a configuration, the resistance values of each phase of the three-phase heater can be calculated more accurately.

When the three resistors are delta-connected, the current value of each phase is not acquired.

When the three resistors are star-connected, the voltage value based on the neutral point 104 is not acquired.

A state in which no current flows through only one of the first electric wire 111, the second electric wire 112, and the third electric wire 113 excluding electric wires through which no current flows in the first and second states is referred to as the third state. The first combined resistance value R1 that is a combined resistance of the three-phase heater 100 in the first state, the second combined resistance value R2 that is a combined resistance of the three-phase heater 100 in the second state, and the third combined resistance value R3 that is a combined resistance of the three-phase heater 100 in the third state are calculated. The resistance value of each phase of the three-phase heater 100 is calculated from the first combined resistance value R1, the second combined resistance value R2, and the third combined resistance value R3.

The first combined resistance value R1 which is the combined resistance of the three-phase heater 100 in the first state and the second combined resistance value R2 which is the combined resistance of the three-phase heater 100 in the second state are calculated. The resistance value of each phase of the three-phase heater 100 is calculated from the first combined resistance value R1, the second combined resistance value R2, and a ratio of the resistance value of each phase of the three-phase heater 100.

The adjustment unit 130 configured to adjust the current supplied to the three-phase heater 100 is provided in at least two of the first electric wire 111, the second electric wire 112, and the third electric wire 113. The adjustment unit 130 is configured to be controlled on and off, and configured such that current is supplied to the three-phase heater 100 when turning on. The line voltage values Vrs, Vst, and Vtr and the line current values Ir, Is, and It in a predetermined period immediately before the adjustment unit 130 is switched from on to off are acquired.

The adjustment unit 130 includes at least two triac solid state relays.

The resistance value of each phase of the three-phase heater 100 is calculated after smoothing the acquired at least two line voltage values Vrs, Vst, and Vtr and the acquired at least two line current values Ir, Is, and It.

The method of the present disclosure can be executed by a computer. That is, the present disclosure includes a program for causing the computer to execute the method of the present disclosure, and a computer-readable storage medium storing the program for causing the computer to execute the method of the present disclosure.

According to the device 1, the following effects can be exhibited.

The device 1 includes the acquisition unit 21 and the calculation unit 22. The acquisition unit 21 is configured to acquire at least two line voltage values among the line voltage value Vrs of the first electric wire 111 and the second electric wire 112, the line voltage value Vst of the second electric wire 112 and the third electric wire 113, and the line voltage value Vtr of the third electric wire 113 and the first electric wire 111, and at least two line current values among the line current value of the first electric wire 111, the line current value of the second electric wire 112, and the line current value of the third electric wire 113. The first electric wire 111, the second electric wire 112, and the third electric wire 113 respectively connect the three-phase heater 100 and the three-phase power supply 120, the three-phase heater 100 including three resistors. The calculation unit 22 is configured to calculate the resistance value of each phase of the three-phase heater 100 based on the acquired at least two line voltage values Vrs, Vst, and Vtr and the acquired at least two line current values Ir, Is, and It. The acquisition unit 21 is configured to acquire the at least two line voltage values Vrs, Vst, and Vtr and the at least two line current values Ir, Is, and It in the first and second states. In the first state, no current flows through only one of the first electric wire 111, the second electric wire 112, and the third electric wire 113. In the second state, no current flows through only one of the two electric wires excluding the electric wire through which no current flows in the first state among the first electric wire 111, the second electric wire 112, and the third electric wire 113. With such a configuration, the resistance value of each phase of the three-phase heater 100 can be calculated from the line voltage values Vrs, Vst, and Vtr and the line current values Ir, Is, and It, so that the resistance value of each phase of the three-phase heater 100 can be easily calculated. In addition, the device 1 can calculate the resistance value of each phase of the three-phase heater 100 using only the instantaneous values of the line voltage values Vrs, Vst, and Vtr and the line current values Ir, Is, and It or only the values obtained by smoothing the instantaneous values.

The method and the device 1 of the present disclosure may be configured as follows.

It is not limited to a case of determining whether or not current is not flowing through an electric wire using the first threshold and the second threshold. For example, when a line current value detected by the current measurement circuit 140 is zero, it may be determined that no current flows through an electric wire.

The acquisition unit 21 may be configured to acquire the line voltage values Vrs, Vst, and Vtr and the line current values Ir, Is, and It via a communication circuit or a communication module for transmitting and receiving data to and from the external device such as the server.

The calculation unit 22 may be configured to use, not limited to the above formulas, but any formula capable of calculating the resistance value of each phase of the three-phase heater 100.

The calculation unit 22 may be configured to calculate the resistance value of each phase of the three-phase heater without performing the smoothing processing on the acquired line voltage values Vrs, Vst, and Vtr and line current values Ir, Is, and It.

The line voltage value and the line current value in the first and second states are not limited to be detected by providing the adjustment unit 130, and may be detected by other methods.

The line current value and the line voltage value are not limited to being measured by the current measurement circuit 140 and the voltage measurement circuit 150, but may be measured by any configuration capable of measuring the line current value or the line voltage value.

Various embodiments of the present disclosure have been described in detail above with reference to the drawings, and finally, various aspects of the present disclosure will be described. In the following description, reference numerals are also added as an example.

A method according to a first aspect of the present disclosure is a method including:

acquiring at least two line voltage values among a line voltage value of a first electric wire 111 and a second electric wire 112, a line voltage value of the second electric wire and a third electric wire 113, and a line voltage value of the third electric wire 113 and the first electric wire 111, and at least two line current values among a line current value of the first electric wire, a line current value of the second electric wire, and a line current value of the third electric wire, the first electric wire, the second electric wire, and the third electric wire respectively connecting a three-phase heater 100 and a three-phase power supply 120, the three-phase heater 100 including three resistors; and

calculating a resistance value of each phase of the three-phase heater 100 based on the acquired at least two line voltage values and the acquired at least two line current values, wherein

the at least two line voltage values and the at least two line current values in each of a first state and a second state are acquired, the first state being a state in which no current flows through only the first electric wire 111, the second state being a state in which no current flows through only the second electric wire 112.

A method according to a second aspect of the present disclosure is the method according to the first aspect, the method including

when the acquired at least two line current values include three acquired line current values, one line current value of the acquired three line current values is less than a first threshold, and remaining two line current values of the acquired three line current values are greater than a second threshold, determining that no current is flowing through an electric wire corresponding to the one current value less than the first threshold.

A method according to a third aspect of the present disclosure is the method according to the first aspect or the second aspect, wherein

when the three resistors are delta-connected, a current value of each phase is not acquired.

A method according to a fourth aspect of the present disclosure is the method according to the first aspect or the second aspect, wherein

when the three resistors are star-connected, a voltage value based on a neutral point 104 is not acquired.

A method according to a fifth aspect of the present disclosure is the method according to any one of the first to fourth aspects, the method including:

calculating a first combined resistance value that is a combined resistance of the three-phase heater 100 in the first state, a second combined resistance value that is a combined resistance of the three-phase heater 100 in the second state, and a third combined resistance value that is a combined resistance of the three-phase heater 100 in a third state, the third state being a state in which no current flows through only the third electric wire 113; and

calculating the resistance value of each phase of the three-phase heater 100 from the first combined resistance value, the second combined resistance value, and the third combined resistance value.

A method according to a sixth aspect of the present disclosure is the method according to any one of the first to fourth aspects, the method including:

calculating a first combined resistance value that is a combined resistance value of the three-phase heater 100 in the first state and a second combined resistance value that is a combined resistance value of the three-phase heater 100 in the second state; and

calculating the resistance value of each phase of the three-phase heater 100 from the first combined resistance value, the second combined resistance value, and a ratio of the resistance value of each phase of the three-phase heater 100.

A method according to a seventh aspect of the present disclosure is the method according to any one of the first to sixth aspects, wherein

an adjustment unit 130 configured to adjust current supplied to the three-phase heater 100 is provided in at least two of the first electric wire 111, the second electric wire 112, and the third electric wire 113, and

the adjustment unit 130 is configured to be controlled on and off, and configured such that current is supplied to the three-phase heater 100 when turning on.

A method according to an eighth aspect of the present disclosure is the method according to the seventh aspect, wherein

the adjustment unit 130 includes at least two triac solid state relays.

A method according to a ninth aspect of the present disclosure is the method according to any one of the first to eighth aspects, wherein

the resistance value of each phase of the three-phase heater is calculated after smoothing the acquired at least two line voltage values and the acquired at least two line current values.

A program according to a tenth aspect of the present disclosure is a program for causing a computer to execute a method including:

acquiring at least two line voltage values among a line voltage value of a first electric wire 111 and a second electric wire 112, a line voltage value of the second electric wire and a third electric wire 113, and a line voltage value of the third electric wire 113 and the first electric wire 111, and at least two line current values among a line current value of the first electric wire, a line current value of the second electric wire, and a line current value of the third electric wire, the first electric wire, the second electric wire, and the third electric wire respectively connecting a three-phase heater 100 and a three-phase power supply 120, the three-phase heater 100 including three resistors; and

calculating a resistance value of each phase of the three-phase heater 100 based on the acquired at least two line voltage values and the acquired at least two line current values, wherein

the at least two line voltage values and the at least two line current values in each of a first state and a second state are acquired, the first state being a state in which no current flows through only the first electric wire 111, the second state being a state in which no current flows through only the second electric wire 112.

A device 1 according to an eleventh aspect of the present disclosure includes:

an acquisition unit 21 configured to acquire at least two line voltage values among a line voltage value of a first electric wire 111 and a second electric wire 112, a line voltage value of the second electric wire and a third electric wire 113, and a line voltage value of the third electric wire 113 and the first electric wire 111, and at least two line current values among a line current value of the first electric wire, a line current value of the second electric wire, and a line current value of the third electric wire, the first electric wire, the second electric wire, and the third electric wire respectively connecting a three-phase heater 100 and a three-phase power supply 120, the three-phase heater 100 including three resistors; and

a calculation unit 22 configured to calculate a resistance value of each phase of the three-phase heater 100 based on the acquired at least two line voltage values and the acquired at least two line current values, wherein

the acquisition unit 21 is configured to acquire the at least two line voltage values and the at least two line current values in each of a first state and a second state, the first state being a state in which no current flows through only the first electric wire 111, the second state being a state in which no current flows through only the second electric wire 112.

By appropriately combining arbitrary embodiments or modifications among the various embodiments or modifications, effects of the respective embodiments and modifications can be obtained. In addition, combinations of the embodiments, combinations of examples, or combinations of the embodiments and the examples can be employed, and combinations of features in different embodiments or examples can also be employed.

Although the present disclosure has been fully described in connection with preferred embodiments with reference to the accompanying drawings, various changes and modifications will be apparent to those skilled in the art. Such changes and modifications are to be understood as being included within the scope of the present disclosure as long as they do not depart from the scope of the present disclosure according to the appended claims.

INDUSTRIAL APPLICABILITY

The present disclosure is applicable to, for example, a device configured to determine abnormality of a three-phase heater.

REFERENCE SIGNS LIST

1      device

11     processor

12     storage unit

21     acquisition unit

22     calculation unit

100    three-phase heater

101    first resistor

102    second resistor

103    third resistor

104    neutral point

111    first electric wire

112    second electric wire

113    third electric wire

120    three-phase power supply

130    adjustment unit

140    current measurement circuit

150    voltage measurement circuit

**Claims**

1.  A method, comprising:

acquiring at least two line voltage values among a line voltage value of a first electric wire and a second electric wire, a line voltage value of the second electric wire and a third electric wire, and a line voltage value of the third electric wire and the first electric wire, and at least two line current values among a line current value of the first electric wire, a line current value of the second electric wire, and a line current value of the third electric wire, the first electric wire, the second electric wire, and the third electric wire respectively connecting a three-phase heater and a three-phase power supply, the three-phase heater including three resistors; and

calculating a resistance value of each phase of the three-phase heater based on the acquired at least two line voltage values and the acquired at least two line current values, wherein

the at least two line voltage values and the at least two line current values in each of a first state and a second state are acquired, the first state being a state in which no current flows through only the first electric wire, the second state being a state in which no current flows through only the second electric wire.

2. The method according to claim 1, comprising,

when the acquired at least two line current values include three acquired line current values, one line current value of the acquired three line current values is less than a first threshold, and remaining two line current values of the acquired three line current values are greater than a second threshold, determining that no current is flowing through an electric wire corresponding to the one current value less than the first threshold.

3. The method according to claim 1 or 2, wherein,

when the three resistors are delta-connected, a current value of each phase is not acquired.

4. The method according to claim 1 or 2, wherein,

when the three resistors are star-connected, a voltage value based on a neutral point is not acquired.

5. The method according to claim 1 or 2, comprising:

calculating a first combined resistance value that is a combined resistance of the three-phase heater in the first state, a second combined resistance value that is a combined resistance of the three-phase heater in the second state, and a third combined resistance value that is a combined resistance of the three-phase heater in a third state, the third state being a state in which no current flows through only the third electric · wire; and

calculating the resistance value of each phase of the three-phase heater from the first combined resistance value, the second combined resistance value, and the third combined resistance value.

6. The method according to claim 1 or 2, comprising:

calculating a first combined resistance value that is a combined resistance of the three-phase heater in the first state and a second combined resistance value that is a combined resistance of the three-phase heater in the second state; and

calculating the resistance value of each phase of the three-phase heater from the first combined resistance value, the second combined resistance value, and a ratio of the resistance value of each phase of the three-phase heater.

7. The method according to claim 1 or 2, wherein,

an adjustment unit configured to adjust current supplied to the three-phase heater is provided in at least two of the first electric wire, the second electric wire, and the third electric wire, and

the adjustment unit is configured to be controlled on and off, and configured such that current is supplied to the three-phase heater when turning on.

8. The method according to claim 7, wherein,

the adjustment unit includes at least two triac solid state relays.

9. The method according to claim 1 or 2, wherein,

the resistance value of each phase of the three-phase heater is calculated after smoothing the acquired at least two line voltage values and the acquired at least two line current values.

10. A program for causing a computer to execute a method comprising:

acquiring at least two line voltage values among a line voltage value of a first electric wire and a second electric wire, a line voltage value of the second electric wire and a third electric wire, and a line voltage value of the third electric wire and the first electric wire, and at least two line current values among a line current value of the first electric wire, a line current value of the second electric wire, and a line current value of the third electric wire, the first electric wire, the second electric wire, and the third electric wire respectively connecting a three-phase heater and a three-phase power supply, the three-phase heater including three resistors; and

calculating a resistance value of each phase of the three-phase heater based on the acquired at least two line voltage values and the acquired at least two line current values, wherein

the at least two line voltage values and the at least two line current values in each of first state and second states are acquired, the first state being a state in which no current flows through only the first electric wire, the second state being a state in which no current flows through only the second electric wire.

11. A device, comprising:

an acquisition unit configured to acquire at least two line voltage values among a line voltage value of a first electric wire and a second electric wire, a line voltage value of the second electric wire and a third electric wire, and a line voltage value of the third electric wire and the first electric wire, and at least two line current values among a line current value of the first electric wire, a line current value of the second electric wire, and a line current value of the third electric wire, the first electric wire, the second electric wire, and the third electric wire respectively connecting a three-phase heater and a three-phase power supply, the three-phase heater including three resistors; and

a calculation unit configured to calculate a resistance value of each phase of the three-phase heater based on the acquired at least two line voltage values and the acquired at least two line current values, wherein

the acquisition unit is configured to acquire the at least two line voltage values and the at least two line current values in each of a first state and a second state, the first state being a state in which no current flows through only the first electric wire, the second state being a state in which no current flows through only the second electric wire.

## Fig. 1

THREE-PHASE POWER SUPPLY 120 → ADJUSTMENT UNIT 130

THREE-PHASE HEATER 100
- FIRST RESISTOR 101
- SECOND RESISTOR 102
- THIRD RESISTOR 103

CURRENT MEASUREMENT CIRCUIT 140

VOLTAGE MEASUREMENT CIRCUIT 150

DEVICE 1
- PROCESSOR 11
- STORAGE UNIT 12
- ACQUISITION UNIT 21
- CALCULATION UNIT 22

**Fig. 2**

EP 4 682 551 A1

Fig. 3

Fig. 4

Fig. 5

Fig. 6

Fig. 7

Fig. 8

Fig. 9

Fig. 10

Fig. 11

Fig. 12

EP 4 682 551 A1

Fig. 13

Fig. 14

Fig. 15

Fig. 16

```
                    ( START )
                        │
   S1  ┌──────────────────────────────────┐
       │        INITIAL SETTING             │
       └──────────────────────────────────┘
                        │
   S2  ┌──────────────────────────────────┐
       │   ACQUIRE LINE VOLTAGE VALUE AND   │
       │        LINE CURRENT VALUE          │
       └──────────────────────────────────┘
                        │
              ARE LINE VOLTAGE
   S3   VALUES AND LINE CURRENT VALUES IN AT LEAST ──── NO
              TWO STATES ACQUIRED?
                        │ YES
   S4  ┌──────────────────────────────────┐
       │        SMOOTHING PROCESSING        │
       └──────────────────────────────────┘
                        │
   S5          IS RESISTANCE
   NO   VALUE CALCULATION CYCLE ELAPSED?
                        │ YES
   S6  ┌──────────────────────────────────┐
       │      CALCULATE RESISTANCE VALUE    │
       └──────────────────────────────────┘
                        │
   S7  ┌──────────────────────────────────┐
       │       STORE RESISTANCE VALUE       │
       └──────────────────────────────────┘
                        │
                    ( END )
```

## INTERNATIONAL SEARCH REPORT

| International application No. |
| --- |
| **PCT/JP2024/006712** |

| A. | CLASSIFICATION OF SUBJECT MATTER |
| --- | --- |

*G01R 27/08*(2006.01)i; *H05B 3/00*(2006.01)i
FI:  G01R27/08; H05B3/00 310C

According to International Patent Classification (IPC) or to both national classification and IPC

| B. | FIELDS SEARCHED |
| --- | --- |

Minimum documentation searched (classification system followed by classification symbols)

G01R27/08; H05B3/00; G01R27/00; G01R31/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2017-20848 A (JAPAN STEEL WORKS LTD.) 26 January 2017 (2017-01-26)<br>entire text, all drawings | 1-11 |
| A | JP 2022-179905 A (AZBIL CORP.) 06 December 2022 (2022-12-06)<br>entire text, all drawings | 1-11 |
| A | JP 2016-110732 A (DAIDO PLANT INDUSTRIES CO., LTD.) 20 June 2016 (2016-06-20)<br>entire text, all drawings | 1-11 |
| A | JP 2020-148697 A (AZBIL CORP.) 17 September 2020 (2020-09-17)<br>entire text, all drawings | 1-11 |

☐ Further documents are listed in the continuation of Box C.       ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **28 March 2024** | **09 April 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/006712**

| Patent document cited in search report | | | Publication date (day/month/year) | Patent family member(s) | Publication date (day/month/year) |
|---|---|---|---|---|---|
| JP | 2017-20848 | A | 26 January 2017 | (Family: none) | |
| JP | 2022-179905 | A | 06 December 2022 | (Family: none) | |
| JP | 2016-110732 | A | 20 June 2016 | (Family: none) | |
| JP | 2020-148697 | A | 17 September 2020 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020148697 A